# EUROPEAN PATENT APPLICATION

(11) **EP 4 600 683 A1**
(43) Date of publication of application: **13.08.2025**
(21) Application number: 24156488.9
(22) Date of filing: 08.02.2024
(51) Int. Cl.: G01R 33/36

(54) **RADIO FREQUENCY ANTENNA ASSEMBLY FOR MAGNETIC RESONANCE**

(71) Applicant: Koninklijke Philips N.V., 5656 AG Eindhoven (NL)
(72) Inventor: VERNICKEL, Peter, Eindhoven (NL); LEUSSLER, Christoph Günther, Eindhoven (NL); FINDEKLEE, Christian, 5656AG Eindhoven (NL)
(74) Representative: Philips Intellectual Property & Standards

(57) **Abstract**

The invention relates to a radio frequency antenna assembly (1) for use in a magnetic resonance examination system (2), comprising an antenna element (3), a control/processing module (4) which is coupled to the antenna element (3) and which is configured for controlling the antenna element (3) and for processing MR data received from the antenna element (3), a galvanic power supply line (5) coupled to the control/processing module (4) to supply electrical power to the control/processing module (4), a control/MR data link (6) coupled to the control/processing module (4) for transmitting MR data received from the antenna element (3) and for transmitting control data for controlling the antenna element (3), and an analysis module (7) that comprises a current/voltage detection unit (11) to derive current/voltage characteristics of the control/processing module (4), the galvanic power supply line (5) and/or the control/MR data link (6), and which is configured to derive a functional status of the radio frequency antenna assembly (1) from the current/voltage characteristics. In this way, a RF antenna assembly is provided that addresses the limitations of the prior art, and enhances reliability, diagnostic capabilities, and overall efficiency in MRI systems.

## Description

### FIELD OF THE INVENTION

The invention relates to the field of magnetic resonance (MR) examination technology, with a particular focus on radio frequency (RF) coils, which are integral components of MR systems.

### BACKGROUND OF THE INVENTION

RF coils in conventional MRI systems are auxiliary units connected to the main system through cables. Despite their crucial role in imaging, the design and functionality of these coils, as they stand today, present several notable challenges and limitations. One of the primary issues with current RF coils is their susceptibility to connection failures, primarily due to regular handling and the frequent need to plug and unplug these devices. This mechanical stress can lead to unreliable performance and necessitates frequent maintenance or replacement.

In conventional configurations, RF coils typically incorporate one or more supply and control wires, along with a fiberoptic connection responsible for data transfer. The fiberoptic connection can serve multiple critical functions, including MR receive data transfer, clock distribution, coil state control, and coil monitoring. However, the requirements for fulfilling these diverse functions overlap only partially. For instance, MR receive data transfer demands a high data rate with a quasi-unidirectional data flow, whereas the control, monitoring, and clock distribution require a low, steady, and time-aligned bidirectional flow. However, a failure in the fiber connection not only disrupts communication but also impedes further analysis of the root cause of the fault. Such a disruption could occur anywhere in the system, from the coil itself to the coil connector or other downstream components, leading to misdiagnoses such as "broken coil". This misdiagnosis can result in unnecessary and costly replacement of components and extended downtime. Furthermore, conventional solutions result in increased power consumption and dissipation. This issue is especially problematic for MRI surface coils, where efficiency and heat management are critical.

In US 2020/0033429 A1 a RF coil array assembly is described which includes an RF coil array with a plurality of coil elements. The coil elements each have an RF conductor that defines an RF path. The coil elements operate in an RF mode for at least one of transmitting RF excitation signals or receiving MRI image signals on the RF conductors. The RF coil array assemblies also include a wireless module connected to the RF coil array, the wireless module including a wireless transceiver operative at a wireless communication frequency band and attached to at least some of the coil elements to provide input and output signals to the at least one wireless module. The coil elements can concurrently transmit or receive wireless communication data and the RF excitation signals or the received MRI image signals.

### SUMMARY OF THE INVENTION

It is an object of the invention to provide a RF antenna assembly that addresses the limitations of the prior art, and enhances reliability, diagnostic capabilities, and overall efficiency in MRI systems.

According to the invention, this object is addressed by the subject matter of the independent claims. Preferred embodiments of the invention are described in the dependent claims.

Therefore, according to the invention, a radio frequency antenna assembly for use in a magnetic resonance examination system is provided which comprises
an antenna element,
a control/processing module which is coupled to the antenna element and which is configured for controlling the antenna element and for processing MR data received from the antenna element,
a galvanic power supply line coupled to the control/processing module to supply electrical power to the control/processing module,
a control/MR data link coupled to the control/processing module for transmitting MR data received from the antenna element and for transmitting control data for controlling the antenna element, and
an analysis module that comprises a current/voltage detection unit to derive current/voltage characteristics of the control/processing module, the galvanic power supply line and/or the control/MR data link, and which is configured to derive a functional status of the radio frequency antenna assembly from the current/voltage characteristics.

It should be noted that the present invention may be used together with digital and/or analog implementations, especially with respect to MR data which may be digital or analog and may, for example, be transmitted as an analog signal via a galvanic cable or as a digital signal via a fiberoptical path.

The antenna element may comprise an electrically conductive coil loop. Controlling the antenna element may comprise tuning and detuning of the electrically conductive coil loop.

According to an embodiment of the invention, the control/data link is comprised of a control data channel for transmitting control data for controlling the antenna element and a MR data channel for transmitting MR data received from the antenna element wherein the control data channel and the MR data channel are separate from each other. In this way, a scheme with two independent data transmission paths is implemented. One channel may be optimized for MR data transmission, the other one for control and diagnostics and time alignment. The channels preferably work as independent digital data streams and the respective communication link may be optical or wireless. The control data channel preferably triggers time critical patient safety relevant incidents like start/stop of MRI or MR/LINAC (linear accelerator) therapy systems and start stop of MRI sequences or threshold/widow-based control of therapy dose. In this respect, it should be mentioned that the way of how the sub-functions are distributed over the streams may vary. In general, all functions besides diagnostics can be done in one stream, so it is possible that the second stream only gets diagnostic functions.

According to an embodiment of the invention, the radio frequency antenna assembly is configured for monitoring the MR data channel by the control data channel and vice versa. For example, reception of a dummy signal of one channel without receiving a signal of the other channel may mean a failure of the other channel and not of the galvanic power supply line. Combining the redundancy info from multiple or even all elements of the assembly may further enhance diagnostic capabilities. On the antenna side, basically shared hardware (microcontroller etc.) can be used to realize the parallel communication channels. However, it is preferred to have two independent controllers.

Having a control data channel and a MR data channel which are separate from each other allows for a comparison of the signals at the output of the control data channel and the MR data channel. This enhances the scope of failure types that the analysis module may distinguish. Notably, when the coil appears to malfunction or not function at all, the analysis module may distinguish whether the issue is with the galvanic power supply line or the with control/data link, or the connections having been improperly plugging the RF antenna to a system host of the respective magnetic resonance examination system.

According to an embodiment of the invention, the control/processing module is configured for submitting a dummy signal via the MR data channel on power-up of the radio frequency antenna assembly. Further, the MR data channel is preferably configured for unidirectional data flow at higher data rates than the control data channel. Preferably, the MR data channel is configured for high data rates at low power consumption and preferably low costs.

According to an embodiment of the invention, the control data channel is configured as a bidirectional channel transmitting and receiving data for steering the antenna element. Preferably, the control data channel requires lower power than the MR data channel. It is also preferred that for the control data channel micro controllers with wireless communication support (WIFI, Bluetooth, 2G/3G/4G/5G and/or proprietary derivatives) are used. In this way, the RF antenna assembly proposed by this invention may incorporate a range of advanced monitoring and control features, designed to enhance its functionality and user experience. One aspect among these features may be a low power tune and detune mechanism of the RF antenna assembly, which may efficiently be managed via standard general-purpose input/output (GPIO). In parallel, the system also may facilitate low power monitoring of the tune and detune status of the RF antenna assembly using the same standard GPIO.

To ensure reliability and safety, the system may include a monitoring feature for the galvanic power supply line. This feature may be particularly adept at detecting intermittent faults, utilizing AD converters for precise measurement. Additionally, the assembly may be equipped with a 3D accelerometer for monitoring the position of the antenna element and detecting any falls, enhancing the overall safety and stability of the device.

The quality of the antenna element may be continuously monitored, focusing on parameters such as the signal-to-noise ratio (SNR), impedances and noise levels, ensuring good performance at all times. The system also may feature adaptive coil tuning, employing a combination of sensors and actuators to automatically adjust for the best performance.

B0 field detection may be another feature of this assembly, allowing for precise control and adjustment in an MRI environment. Environmental sensing capabilities may be integrated as well, including the monitoring of humidity, temperature, and pressure, which may be essential for maintaining the integrity and performance of the device in varying conditions.

Further enhancing its functionality, the system may monitor other local functions such as the temperature of modules and the performance of voltage converters. This comprehensive monitoring ensures all aspects of the device are functioning correctly.

To improve the user experience, the assembly may provide for optical and/or haptic feedback to both an operator and a patient, ensuring clear and intuitive communication of the assembly's status and any necessary actions. Additionally, the system may be capable of collecting and processing patient vital signs data, a helpful aspect for patient monitoring during MRI procedures.

Further, the assembly may include features for patient communication and entertainment, recognizing the importance of patient comfort and engagement during MRI scans. This holistic approach to the design of the RF antenna assembly not only enhances its technical capabilities but also significantly improves the overall experience for both the operator and the patient.

According to an embodiment of the invention, wherein the control/processing module comprises a buffer for supply power. Preferably the buffer for supply power comprises a capacitor or a battery. In this way, diagnostics can run for a certain time after a power supply issue or unplugging the assembly.

According to an embodiment of the invention, the control/processing module is configured for consecutively submitting a status signal to a host as a function check via the control data channel.

Preferably, status signals are submitted regularly at constant time intervals via the control data channel. Further, it is preferred that the control/processing module comprises an analogue-to-digital converter and a pre-amplifier which are electrically powered over the galvanic power supply line. Magnetic resonance signals acquired by the magnetic flux capturing antenna element are pre-amplified and digitized in the control/processing module. Preferably, the analysis module is configured as a plug-in device which can be coupled to a conventional RF antenna assembly.

Further, according to the invention, a method for operating a radio frequency antenna assembly of a magnetic resonance examination system, is provided wherein the radio frequency antenna assembly comprises an antenna element, a galvanic power supply line, and a control/processing module which is coupled to the antenna element, and the method comprises the following method steps:
supplying electrical power to the control/processing module via the galvanic power supply line,
controlling the antenna element and processing MR data received from the antenna element by the control/processing module,
transmitting MR data received from the antenna element from the control/processing module to a host via a control/MR data link and transmitting control data for controlling the antenna element from the host to the control/processing module via the control/MR data link,
deriving current/voltage characteristics of the control/processing module, the galvanic power supply line and/or the control/MR data link, and
deriving a functional status of the radio frequency antenna assembly from the current/voltage characteristics.

According to an embodiment of the invention, the control/data link is comprised of a control data channel for transmitting control data for controlling the antenna element and a MR data channel for transmitting MR data received from the antenna element wherein the control data channel and the MR data channel are separate from each other. Preferably, the MR data channel is monitored by the control data channel and vice versa.

According to an embodiment of the invention, a dummy signal is submitted via the MR data channel on power-up of the radio frequency antenna assembly. Preferably, a status signal is consecutively submitted to the host as a function check via the control data channel.

According to the invention, a computer program for a radio frequency antenna assembly as described above is provided which comprises instructions which, when the program is executed by a computer, cause the computer to perform a method as described before.

Furthermore, according to the invention, a magnetic resonance examination system with a radio frequency antenna assembly as described further above is provided.

Therefore, in various embodiments of the claimed invention, a comprehensive approach to communication channels and their optimization is presented to enhance the performance and functionality of radio frequency coils in magnetic resonance examination systems. In one embodiment, a first communication channel is meticulously optimized to deliver high data rates while maintaining low power consumption and cost-effectiveness. Preferably, this channel employs fiberoptic transmission to achieve these data rates efficiently. Preferably, it operates primarily as a unidirectional channel, effectively serving its intended purpose. Moreover, this embodiment allows for daisy-chaining of coil modules, further enhancing the scalability and versatility of the system.

In an embodiment, a second communication channel takes a bidirectional approach, facilitating the transmission and reception of all data necessary to control the RF coil. Preferably, this channel operates at lower power requirements compared to the first one. To ensure uninterrupted operation, a supply power buffer, such as a capacitor or battery, is integrated, enabling diagnostics to continue functioning for a certain period even after power supply disruptions or device unplugging. State-of-the-art microcontrollers with support for wireless communication standards may be employed, allowing for a wide range of functionalities, both existing and future. These functionalities include low power tune and detune of the coil, monitoring of tune and detune status, power supply line fault detection using AD converters, tracking coil position and fall detection through a 3D accelerometer, monitoring of coil quality (e.g., signal-to-noise ratio and noise levels), adaptive coil tuning using sensors and actuators, B0 field detection, environmental sensing (humidity, temperature, pressure, etc.), and monitoring of other local functions such as module temperature and voltage converter performance. Additionally, optical or haptic feedback may be provided to both the operator and the patient, and vital signs data may be collected from the patient. Communication and entertainment features may also be integrated into the system to enhance the patient's experience.

Furthermore, the second communication channel may routinely submit a status signal to the host, ensuring continuous function checks and system reliability. Preferably, these communication channels are designed to monitor each other, allowing for the detection of failures or disruptions. For instance, the absence of signals in the second channel while receiving the dummy signal from the first channel would indicate a failure in the second channel rather than a power supply issue. Combining redundancy information from all coil elements further strengthens the diagnostic capabilities of the system.

In an embodiment catering to clinical applications such as spectroscopy and radiation therapy, RF coils serve as multi-sensor interfaces between patients and diagnostic systems. Patient safety is a top priority in these scenarios, necessitating the inclusion of a second independent communication link as an additional safety measure. This embodiment preferably encompasses independent RF channels operating at different MRI frequencies, a second channel dedicated to noise detection for AI-based noise reduction, a second channel for integrating patient safety sensor devices, particularly relevant in oncology, for monitoring local RF electromagnetic fields and temperature and/or an integrated vital signs data link for triggering with minimal latency.

Preferably, the second channel operates entirely independently of the RF coil power supply. It may be supplied with power through an integrated battery under the control of a safety power monitoring unit, ensuring continuous safety monitoring and data transmission even in the event of power disruptions.

### BRIEF DESCRIPTION OF THE DRAWINGS

These and other aspects of the invention will be apparent from and elucidated with reference to the embodiments described hereinafter. Such an embodiment does not necessarily represent the full scope of the invention, however, and reference is made therefore to the claims and herein for interpreting the scope of the invention.

In the drawings:
Fig. 1 schematically depicts a radio frequency antenna assembly according to an embodiment of the invention,
Fig. 2 schematically depicts a radio frequency antenna assembly according to another embodiment of the invention, and
Fig. 3 schematically depicts a MR examination system with a radio frequency antenna assembly according to an embodiment of the invention.

### DETAILED DESCRIPTION OF EMBODIMENTS

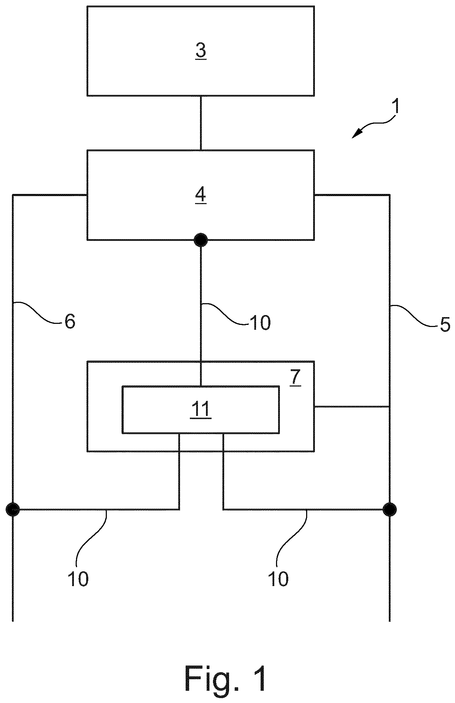

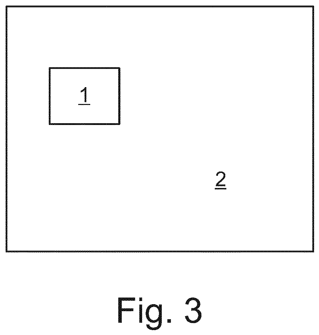

Fig. 1 schematically depicts a radio frequency antenna assembly 1 according to an embodiment of the invention. As can be seen from Fig. 3, the radio frequency antenna assembly 1 is part of a MR examination system 2. The radio frequency antenna assembly 1 comprises an antenna element 3, a control/processing module 4 which is coupled to the antenna element 3 and which is configured for controlling the antenna element 3 and for processing MR data received from the antenna element 3, a galvanic power supply line 5 coupled to the control/processing module 4 to supply electrical power to the control/processing module 4, a control/MR data link 6 coupled to the control/processing module 4 for transmitting MR data received from the antenna element 3 and for transmitting control data for controlling the antenna element 3, and an analysis module 7 that comprises a current/voltage detection unit 11 to derive current/voltage characteristics of the control/processing module 4, the galvanic power supply line 5 and/or the control/MR data link 6, and which is configured to derive a functional status of the radio frequency antenna assembly 1 from the current/voltage characteristics. Further, the antenna assembly 1 comprises a current/voltage detection unit 11 which is coupled to the galvanic power supply line 5 and to the control/MR data link via test lines 10.

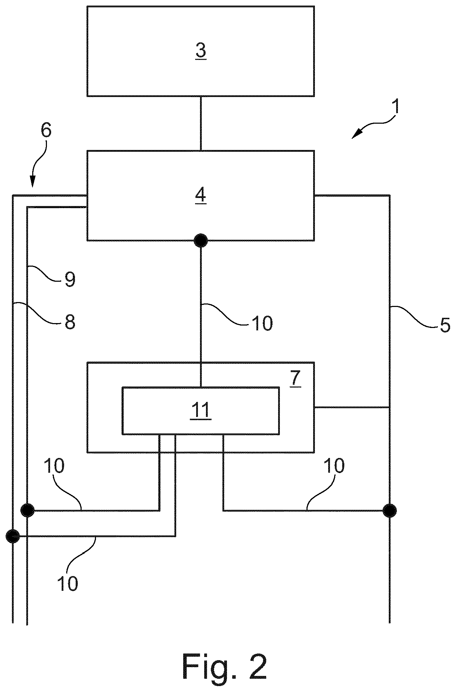

While the embodiment shown in Fig. 1 is equipped with a control/data link 6 which comprises only one single data channel for transmitting control data for controlling the antenna element 3 and for transmitting MR data received from the antenna element 3, the embodiment shown in Fig. 2 is equipped with a control/data link 6 which is comprised of a control data channel 8 for transmitting control data for controlling the antenna element 3 and a MR data channel 9 for transmitting MR data received from the antenna element 3 wherein the control data channel 8 and the MR data channel 9 are separate from each other. The MR data channel 9 is configured for unidirectional data flow at higher data rates than the control data channel 8. The control data channel 8 is configured as a bidirectional channel transmitting and receiving data for steering the antenna element 3.

This provides for certain advantages since this approach establishes a system featuring two separate data transmission routes. One channel can be fine-tuned for efficient MR data transmission, while the other is designed for control, diagnostics, and precise timing alignment. These channels operate as autonomous digital data streams, with communication links that can be either optical or wireless in nature. The control data channel 8 is primarily responsible for initiating time-critical actions related to patient safety, such as (de-)tuning of coils, initiating or stopping MRI or MR/LINAC (linear accelerator) therapy systems, commencing or halting MRI sequences, or implementing threshold and window-based control over therapy dosage. Especially, the control data channel 8 is responsible for time aligning the individual digitizers. Time alignment in this context is used as a synonym for clock distribution so that all digitizers work on the same temporal reference.

Further, the radio frequency antenna assembly 1 according to Fig. 2 is configured for monitoring the MR data channel 9 by the control data channel 8 and vice versa. For instance, if one channel receives a dummy signal but does not receive a signal from the other channel, it suggests a potential failure in the latter channel, rather than indicating an issue with the galvanic power supply line 5. By consolidating redundancy information from multiple or all components of the assembly, diagnostic capabilities may be further enhanced.

On the antenna side, shared hardware, such as a microcontroller, may be used to facilitate parallel communication channels, as explained further above. The separation of the control data channel 8 and the MR data channel 9 makes it possible to compare signals at their respective outputs. This expanded capability broadens the range of failure types that the analysis module 7 can identify. Notably, in cases where the coil exhibits malfunctions or fails to function altogether, the analysis module 7 can distinguish whether the issue lies with the galvanic power supply line 5, the control/data link 6, or improper connections when plugging the antenna element 3 into the system host of the magnetic resonance examination system 2.

Furthermore, the control/processing module 4 is configured for submitting a dummy signal via the MR data channel 9 on power-up of the radio frequency antenna assembly 1 and the control/processing module 4 is configured for consecutively submitting a status signal to a host as a function check via the control data channel 8.

With a radio frequency antenna assembly 1 according to Fig. 1 or Fig. 2 a method becomes possible which comprises the following method steps:
- supplying electrical power to the control/processing module 4 via the galvanic power supply line 5,
- controlling the antenna element 3 and processing MR data received from the antenna element 3 by the control/processing module 4,
- transmitting MR data received from the antenna element 3 from the control/processing module 4 to a host via a control/MR data link 6 and transmitting control data for controlling the antenna element 3 from the host to the control/processing module 4 via the control/MR data link 6,
- deriving current/voltage characteristics of the control/processing module 4, the galvanic power supply line 5 and/or the control/MR data link 6, and
- deriving a functional status of the radio frequency antenna assembly 1 from the current/voltage characteristics.

In case of the embodiment of Fig. 2 where the control/data link 6 is comprised of a control data channel 8 for transmitting control data for controlling the antenna element 3 and a MR data channel 9 for transmitting MR data received from the antenna element 3 wherein the control data channel 8 and the MR data channel 9 are separate from each other, the MR data channel 9 is monitored by the control data channel 8 and vice versa. Further, for control purposes, a dummy signal is submitted via the MR data channel 9 on power-up of the radio frequency antenna assembly 1. In addition, a status signal is consecutively submitted to the host as a function check via the control data channel 8.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope. Further, for the sake of clearness, not all elements in the drawings may have been supplied with reference signs.

**REFERENCE SYMBOL LIST**

| | |
|---|---|
| radio frequency antenna assembly | 1 |
| magnetic resonance examination system | 2 |
| antenna element | 3 |
| control/processing module | 4 |
| galvanic power supply line | 5 |
| control/MR data link | 6 |
| analysis module | 7 |
| control data channel | 8 |
| MR data channel | 9 |
| test lines | 10 |
| current/voltage detection unit | 11 |

## Claims

1. Radio frequency antenna assembly (1) for use in a magnetic resonance examination system (2), comprising
an antenna element (3),
a control/processing module (4) which is coupled to the antenna element (3) and which is configured for controlling the antenna element (3) and for processing MR data received from the antenna element (3),
a galvanic power supply line (5) coupled to the control/processing module (4) to supply electrical power to the control/processing module (4),
a control/MR data link (6) coupled to the control/processing module (4) for transmitting MR data received from the antenna element (3) and for transmitting control data for controlling the antenna element (3), and
an analysis module (7) that comprises a current/voltage detection unit (11) to derive current/voltage characteristics of the control/processing module (4), the galvanic power supply line (5) and/or the control/MR data link (6), and which is configured to derive a functional status of the radio frequency antenna assembly (1) from the current/voltage characteristics.

2. Radio frequency antenna assembly (1) according to claim 1, wherein the control/data link (6) is comprised of a control data channel (8) for transmitting control data for controlling the antenna element (3) and a MR data channel (9) for transmitting MR data received from the antenna element (3) wherein the control data channel (8) and the MR data channel (9) are separate from each other.

3. Radio frequency antenna assembly (1) according to claim 2, wherein the radio frequency antenna assembly (1) is configured for monitoring the MR data channel (9) by the control data channel (8) and vice versa.

4. Radio frequency antenna assembly (1) according to claim 2 or 3, wherein the control/processing module (4) is configured for submitting a dummy signal via the MR data channel (9) on power-up of the radio frequency antenna assembly (1).

5. Radio frequency antenna assembly (1) according to any one of claims 2 to 4, wherein the MR data channel (9) is configured for unidirectional data flow at higher data rates than the control data channel (8).

6. Radio frequency antenna assembly (1) according to any one of claims 2 to 5, wherein the control data channel (8) is configured as a bidirectional channel transmitting and receiving data for steering the antenna element (3).

7. Radio frequency antenna assembly (1) according to any one of claims 2 to 6, wherein the control/processing module (4) is configured for consecutively submitting a status signal to a host as a function check via the control data channel (8).

8. Method for operating a radio frequency antenna assembly (1) of a magnetic resonance examination system (2),
the radio frequency antenna assembly (1) comprising an antenna element (3), a galvanic power supply line (5), and a control/processing module (4) which is coupled to the antenna element (3),
the method comprising the following method steps:
- supplying electrical power to the control/processing module (4) via the galvanic power supply line (5),
- controlling the antenna element (3) and processing MR data received from the antenna element (3) by the control/processing module (4),
- transmitting MR data received from the antenna element (3) from the control/processing module (4) to a host via a control/MR data link (6) and transmitting control data for controlling the antenna element (3) from the host to the control/processing module (4) via the control/MR data link (6),
- deriving current/voltage characteristics of the control/processing module (4), the galvanic power supply line (5) and/or the control/MR data link (6), and
- deriving a functional status of the radio frequency antenna assembly (1) from the current/voltage characteristics.

9. Method according to claim 8, wherein the control/data link (6) is comprised of a control data channel (8) for transmitting control data for controlling the antenna element (3) and a MR data channel (9) for transmitting MR data received from the antenna element (3) wherein the control data channel (8) and the MR data channel (9) are separate from each other.

10. Method according to claim 9, wherein the MR data channel (9) is monitored by the control data channel (8) and vice versa.

11. Method according to claim 9 or 10, wherein the control/processing module (4) a dummy signal is submitted via the MR data channel (9) on power-up of the radio frequency antenna assembly (1).

12. Method according to any one of claims 9 to 11, wherein a status signal is consecutively submitted to the host as a function check via the control data channel (8).

13. Computer program for a radio frequency antenna assembly (1) according to any one of claims 1 to 7, comprising instructions which, when the program is executed by a computer, cause the computer to perform a method according to any one of claims 8 or 12.

14. Magnetic resonance examination system (2) with a radio frequency antenna assembly (1) according to any one of the claims 1 to 7.
